# EUROPEAN PATENT SPECIFICATION

(11) **EP 1 081 773 B1**
(45) Date of publication and mention of the grant of the patent: **14.01.2009**
(21) Application number: 00307394.7
(22) Date of filing: 29.08.2000
(51) Int. Cl.: H01L 41/24, H01L 41/187, C04B 35/475

(54) **Method of manufacturing a sintered (Bi,Na)TiO3 piezoelectric body**
Herstellungsverfahren für einen gesinterten piezoelektrischen Körper aus (Bi,Na)TiO3
Procédé de fabrication d'un corps piézoélectrique fritte de (Bi,Na)TiO3

(30) Priority: 31.08.1999 JP 24628899; 08.09.1999 JP 25461799; 07.08.2000 JP 2000238738
(43) Date of publication of application: 07.03.2001
(73) Proprietor: NGK INSULATORS, LTD., Nagoya-City, Aichi Pref. 467-8530 (JP)
(72) Inventor: Yamaguchi, Hirofumi, NGK Insulators, Ltd., Nagoya-city, Aichi-Prefecture 467-8530 (JP); Koizumi, Takaaki, NGK Insulators, Ltd., Nagoya-city, Aichi-Prefecture 467-8530 (JP)
(74) Representative: Paget, Hugh Charles Edward

(56) References cited:
- JP-A- 10 324 569
- US-A- 5 637 542
- NAGATA H ET AL: "Lead-free piezoelectric ceramics of (Bi1/2Na1/2)TiO3-1/2(Bi2O3.Sc2O3) system" FERROELECTRIC MATERIALS AND THEIR APPLICATIONS. 14TH MEETING, KYOTO, JAPAN, 28-31 MAY 1997, vol. 36, no. 9B, pages 6055-6057, XP002268188 Japanese Journal of Applied Physics, Part 1 (Regular Papers, Short Notes & Review Papers), Sept. 1997, Publication Office, Japanese Journal Appl. Phys, Japan ISSN: 0021-4922
- TAKENAKA T ET AL: "Present status of non-lead-based piezoelectric ceramics" ELECTROCERAMICS IN JAPAN. 17TH ELECTRONICS DIVISION MEETING OF THE CERAMIC SOCIETY OF JAPAN, KAWASAKI, JAPAN, 27-28 OCT. 1997, vol. 157-158, pages 57-64, XP001157077 Key Engineering Materials, 1999, Trans Tech Publications, Switzerland ISSN: 1013-9826
- NAGATA H ET AL: "Lead-free piezoelectric ceramics of (Bi1/2Na1/2)TiO3-KNbO3-1/2(Bi2O3.Sc2O3) system" FERROELECTRIC MATERIALS AND THEIR APPLICATIONS, KYOTO, JAPAN, 27-30 MAY 1998, vol. 37, no. 9B, pages 5311-5314, XP002268189 Japanese Journal of Applied Physics, Part 1 (Regular Papers, Short Notes & Review Papers), Sept. 1998, Publication Office, Japanese Journal Appl. Phys, Japan ISSN: 0021-4922
- TAKENAKA T ET AL: "Ferroelectric and piezoelectric properties of lead-free (Bi1/2Na1/2)TiO3-KNbO3-1/2(Bi2O3.Sc2O3) ceramics" APPLICATIONS OF FERROELECTRICS, 1998. ISAF 98. PROCEEDINGS OF THE ELEVENTH IEEE INTERNATIONAL SYMPOSIUM ON MONTREUX, SWITZERLAND 24-27 AUG. 1998, PISCATAWAY, NJ, USA,IEEE, US, 24 August 1998 (1998-08-24), pages 559-562, XP010347252 ISBN: 0-7803-4959-8

## Description

### BACKGROUND OF THE INVENTION

The present invention relates to method of forming a piezoelectric body which is e.g. a fired ceramic or porcelain. The piezoelectric body may be utilized in an actuator and a sensor which are integrated as an electromechanical transducer used for positioning a precision machine tool, controlling an optical path in an optical apparatus, a valve for controlling a flow rate, an ultrasound motor and a brake apparatus of an automobile.

The piezoelectric body may also be used in an element for measuring the properties of liquid and an element for measuring a minute mass.

A piezoelectric body is a material having the effect of converting electric energy into mechanical energy, by which distortion is generated when an external electric field is applied thereto and the effect of converting mechanical energy into electric energy, by which electric charge is generated when a mechanical stress is applied.

One piezoelectric material which is utilized in an actuator, a filter and various sensors, is a material containing (Bi_{1/2}Na_{1/2})TiO₃ as a main component and, a three-component system of piezoelectric porcelain composition which consists of this material, MeNbO₃ (Me is K or Na) and Bi₂O₃ ■ Sc₂O₃. This material is disclosed, for example, in JP-A 10-324569.

Although the above piezoelectric porcelain composition disclosed in JP-A 10-324569 is a three-component system material containing (Bi_{1/2}Na_{1/2})TiO₃ as a main component, MeNbO₃ (Me is K or Na) and Bi₂O₃ ■ Sc₂O₃, the composition has high polarization voltage and, thus, it has as high as about 30% frequency of producing dielectric breakdown during polarization.

Another document disclosing the manufacture of a BNT sintered BNT piezoelectric material is US-A-5637542. In these prior art disclosures, the material is made by mixing raw material powders of the component oxides, calcining these powders, pulverising the resulting calcined material, drying it, compacting the powder and firing it to produce the sintered product.

### SUMMARY OF THE INVENTION

It is an object of the present invention to overcome the above-discussed drawbacks in the prior art. To that end, the present invention provides method of forming a piezoelectric body containing (Bi_{1/2}Na_{1/2})TiO₃ as a main component, but nevertheless has reduced frequency of producing dielectric breakdown during polarization.

In accordance with the present invention, their is provided a method as set out in claim 1. In the sintered piezoelectric body so formed, there is a dramatically reduced frequency of producing dielectric breakdown to 0.1 to 2% when the material is polarized at 6 kV/mm, relative to the breakdown frequency in the prior art piezoelectric body.

In addition since the powder or powders used to form the piezoelectric body has a heterogeneous phase present in an extremely small amount relative to the main phase, the crystal phase in the fired body is preferably formed into a single (Bi_{1/2}Na_{1/2})TiO₃ system perovskite phase. Accordingly, the piezoelectric body also has high dielectric breakdown strength.

The piezoelectric body may be made using a process sequence of mixing and calcination of raw material powders, wet grinding the powders with a ball mill to form a slurry and, then, forming and sintering the dried powders. Unground powders and aggregates containing a heterogeneous phase are removed by passing the ground slurry through a sieve before drying the slurry. Since a heterogeneous phase produced during the calcination step is more difficult to be ground as compared with the main perovskite phase, it easily remains as coarse particles even after the grinding treatment. Therefore, separation of the heterogeneous phase becomes possible by appropriately selecting a size of an aperture of a sieve depending upon grinding time.

In addition, grinding time is preferably as short as 2 to 4 hours in order not to cause micronization of heterogeneous phase particles and to inhibit aggregation of particles. It is desirable that the specific surface area of the powders is not greater than 8 m²/g and not smaller than 2 m²/g.

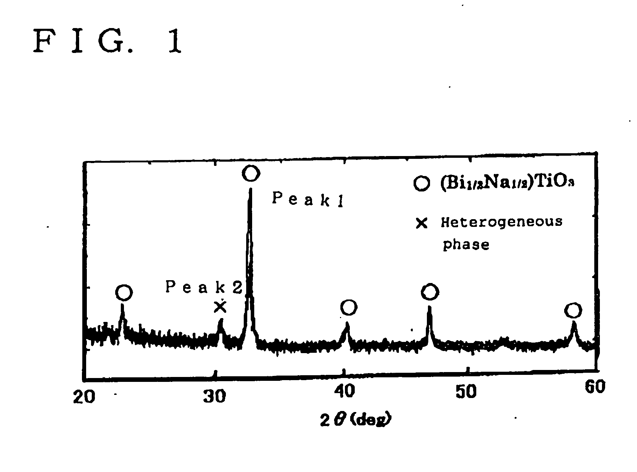

For detecting a heterogeneous phase, the conventional X-ray powder diffraction method was used. With reference to Fig. 1, the peak intensity of peak 1, which is the strongest peak among peaks of the (Bi_{1/2}Na_{1/2})TiO₃ perovskite phase, and that of peak 2, which is the strongest peak of the heterogeneous phase other than the perovskite phase, are measured. The peak intensity ratio of the peak intensity of peak 2 to that of peak 1 is then calculated.

In addition, MeNbO₃ (Me is Na or K), Sc₂O₃ "Bi₂ O₃ and the like in addition to (Bi_{1/2}Na_{1/2})TiO₃ may be added thereto as a form of substitution or solid solution. In addition, in the porcelain of the present invention, Zr, Si and the like may be irreversibly contained at an amount of 0.5 wt% or smaller.

The piezoelectric body produced by the present invention is excellent in displacement properties, and this is useful as a general electromechanical transducing element and is suitably utilized as a well-densified thick film or a thin film such as an actuator, a sensor and the like.

For example, a diaphragm substrate having a thin diaphragm portion 3 to 50 µm thickness, preferably 5 to 15 µm, is prepared using sintered zirconia or alumina, preferably partially stabilized zirconia. As a preferable shape of this substrate, an outwardly convex shape in an opposite direction to a window part in a thin diaphragm which is integrally laminated so as to cover a window of a ceramic substrate described in JP-A 8-51238, and a diaphragm shape in which a flat part or a curved part having a predetermined curvature is formed on a convex top part or a part containing the same at a diaphragm part described in JP-A 8-130334 are desirable. A heat-resistant metal film of Pt, Pt-Pd alloy or the like having a thickness of 1 to 10 µm as a lower electrode is formed on the surface of a thin part of this substrate. A piezoelectric body relating to the present invention is formed on this lower electrode by a thick film method and fired at a temperature of 1000 to 1250°C. As a thick film method, a dipping method, a screen printing method, spin coater method and the like can be used. Preferably, a screen printing method is used. The thickness of a piezoelectric body after firing is preferably 1 to 40 µm and, more preferably, 5 to 25 µm. Pt, Au, Ag, Cu and the like, preferably, Au or Ag as an upper electrode is formed on the formed piezoelectric film so that the thickness is 2 µm or smaller.

The piezoelectric body thus formed is suitably utilized in a fine sensor or an actuator used in an element for measuring the properties of liquid or an element for measuring a minute mass disclosed in JP-A 8-201265.

### BRIEF DESCRIPTION OF DRAWING

Fig. 1 is an X-ray powder diffraction pattern of a powder compositon used in the present invention.

### DETAILED DESCRIPTION OF THE INVENTION

The present invention will now be explained by way of the following examples.

### Example 1

First, bismuth oxide (Bi₂O₃), sodium hydrogen tartrate (NaHC₄H₄O₆) and titanium oxide (TiO₂) as raw materials were dried, weighed at an appropriate component ratio to give (Bi_{1/2}Na_{1/2})TiO₃ in a final fired body and wet-mixed with an ethanol solvent for 16 hours using 2 mm zirconia balls. The mixture was dried, calcined at 900°C for 2 hours in the atmosphere and wet ground in a ball mill for 2 hours. Powders in the slurry state after grinding were passed through 420 mesh nylon sieve to remove unground materials and aggregated materials and then dried. The crystal phase of the dried powders was examined by X-ray diffraction.

Then, a 20φ×10t molded pellet was formed using the dried powders by a press method and fired at 1150°C for 2 hours in the atmosphere. The porcelain obtained by firing was machined into a dimension of length 12mm, width 3mm and thickness lmm and a polarization electric field of 6 kV/mm was applied for 10 minutes in a thickness direction in a silicone oil. The frequency of dielectric breakdown during the polarization treatment was recorded.

### Example 2

Example 2 is a sample made using the same conditions from Example 1, except that grinding after calcination treatment was performed for 4 hours.

### Example 3

Example 3 is a sample made using the same conditions from Example 1, except that the calcination temperature was 850°C.

### Comparative Example 1

The same conditions as those of the aforementioned Example 1 were used, except that grinding was performed with a ball mill for 10 hours instead of 2 hours after calcination.

### Comparative Example 2

The same conditions as those of the aforementioned Example 1 were used except that the slurry powders after grinding were dried without passing through a 420 mesh sieve.

The results recording the frequency of dielectric breakdown when these samples were polarized as well as the results of X-ray diffraction of the powders are shown in Table 1.

**Table 1**

| | Ratio of heterogeneous phase in powders (%) | Ratio of dielectric breakdown (%) |
|---|---|---|
| Example 1 | 1 | 0.1 |
| Example 2 | 3 | 0.5 |
| Example 3 | 5 | 2 |
| Comparative Example 1 | 7 | 30 |
| Comparative Example 2 | 10 | 50 |

These results show that dielectric breakdown during polarization can be reduced to 0.1 to 2% if the amount of heterogeneous phase is maintained at 5% or less.

Since the frequency of producing dielectric breakdown during polarization of a sintered piezoelectric body obtained by forming and sintering powders in which a peak intensity ratio (by powder X-ray diffraction) of a heterogeneous phase other than a (Bi_{1/2}Na_{1/2})TiO₃ perovskite phase in the powders is 5% or smaller relative to the strongest peak of the (Bi_{1/2}Na_{1/2})TiO₃ system perovskite phase as a main component can be dramatically reduced to 0.1 to 2%, that is, several tenth to several hundredth relative to breakdown frequency in the prior art piezoelectric body, manufacturing yield is increased and manufacturing cost can be reduced as compared with the prior art piezoelectric body. Additionally, the reliability of the product such as an actuator, a sensor and the like can be improved.

In addition, since the piezoelectric body produced by the present invention has the property of low reactivity with other materials when fired in the presence of other materials, such as placing the piezoelectric body on other materials, it does not reduce the inherent property of a piezoelectric body and, since the present piezoelectric body has low influence on other materials, it does not damage (e.g.,crack) other materials. Therefore, a remarkable improvement in total reliability in the final product is attained together with a dramatic decrease in dielectric breakdown frequency.

## Claims

1. A method of forming a sintered piezoelectric body having as a main component the (Bi_{1/2}Na_{1/2}) TiO₃ perovskite phase, comprising the steps of:
(i) forming a powder in which the main component is the (Bi_{1/2}Na_{1/2})TiO₃ perovskite phase and no other component is present having a peak intensity of the strongest x-ray diffraction peak, as determined by powder x-ray diffraction, which is greater than 5% of the peak intensity of the strongest x-ray diffraction peak of the (Bi_{1/2}Na_{1/2}) TiO₃ perovskite phase; and
(ii) compacting and firing the powder to form the sintered body.

2. A method according to claim 1, wherein said powder is obtained by mixing and calcining raw material powders to form the (Bi_{1/2}Na_{1/2}) TiO₃ phase, wet grinding the calcined material in a ball mill to form a slurry, passing the powder in a slurry state through a 420 mesh sieve and drying the powder.

3. A method according to claim 2, wherein the grinding in said ball mill is carried out for a time in the range 2 to 4 hours.

## Patentansprüche

1. Verfahren zur Ausbildung eines piezoelektrischen Sinterkörpers mit einer (Bi_{1/2}Na_{1/2})TiO₃-Perowskitphase als Hauptkomponente, folgende Schritte umfassend:
(i) die Ausbildung eines Pulvers, worin die Hauptkomponente die (Bi_{1/2}Na_{1/2})TiO₃-Perowskitphase ist und keine andere Komponente vorliegt, die eine wie mittels Pulver-Röntgenbeugung ermittelte Reflexintensität des stärksten Röntgenbeugungsreflexes aufweist, die stärker als 5 % der Reflexintensität des stärksten Röntgenbeugungsreflexes der (Bi_{1/2}Na_{1/2})TiO₃-Perowskitphase ist; und
(ii) die Kompaktierung und das Brennen des Pulvers zur Ausbildung des Sinterkörpers.

2. Verfahren nach Anspruch 1, worin das Pulver durch Vermischen und Kalzinieren von Rohmaterialpulvern zur Bildung der (Bi_{1/2}Na_{1/2})TiO₃-Perowskitphase, Nassmahlung des kalzinierten Materials in einer Kugelmühle zur Bildung einer Aufschlämmung, Passieren des Pulvers im aufgeschlämmten Zustand durch ein 420-Mesh-Sieb und Trocknen des Pulvers erhalten wird.

3. Verfahren nach Anspruch 2, worin das Mahlen in der Kugelmühle in einem Zeitraum von 2 bis 4 h durchgeführt wird.

## Revendications

1. Procédé de fabrication d'un corps piézoélectrique fritté ayant comme composant principal la phase (Bi_{1/2}Na_{1/2}) TiO₃ pérovskite, comprenant les étapes de:
(i) former une poudre dans laquelle le composant principal est la phase (Bi_{1/2} Na_{1/2}) TiO₃ pérovskite et aucun autre composant est présent ayant une intensité de crête de la crête de diffraction des rayons X la plus forte, comme déterminée par la diffraction des rayons X des poudres, qui est plus grande que 5% de l'intensité de crête de la crête de diffraction des rayons X la plus forte de la phase (Bi_{1/2}Na_{1/2}) TiO₃ pérovskite; et
(ii) compacter et cuire la poudre pour former le corps fritté.

2. Procédé selon la revendication 1, où ladite poudre est obtenue en mélangeant et en calcinant des poudres de matériau brut pour former la phase (Bi_{1/2}Na_{1/2}) TiO₃, par broyage humide du matériau calciné dans un broyeur à boulets pour former une boue, le passage de la poudre en un état de boue à travers un tamis à maille 420 et le séchage de la poudre.

3. Procédé selon la revendication 2, où le broyage dans ledit broyeur à boulets est exécuté pendant un temps dans la plage de 2 à 4 heures.
